# EUROPÄISCHE PATENTSCHRIFT

(11) **EP 2 009 974 B1**
(45) Veröffentlichungstag und Bekanntmachung des Hinweises auf die Patenterteilung: **11.08.2010**
(21) Anmeldenummer: 07012786.5
(22) Anmeldetag: 29.06.2007
(51) Int. Cl.: H05K 7/20

(54) **Schaltgerät mit zwei gesteuerten Phasen**
Switching device with two controlled phases
Commutateur doté de deux phases commandées

(43) Veröffentlichungstag der Anmeldung: 31.12.2008
(73) Patentinhaber: SIEMENS AKTIENGESELLSCHAFT, 80333 München (DE)
(72) Erfinder: Meier, Markus, 92286 Rieden (DE); Seitz, Johann, 92224 Amberg (DE)

(56) Entgegenhaltungen:
- US-A- 6 049 459
- US-A1- 2005 088 831
- US-A1- 2005 280 998

## Beschreibung

Die Erfindung betrifft ein Schaltgerät mit zwei gesteuerten Phasen.

Elektronische Schaltgeräte dienen in der Regel zur Vorschaltung vor elektrische Lasten, beispielsweise vor eine 3-polige motorische Last. Derartige Schaltgeräte weisen hierbei drei oder auch nur zwei eigentlich geschaltete, d.h. gesteuerte Phasen auf. Schaltgeräte mit zwei geschalteten Phasen stellen hierbei ein technisch- wirtschaftliches Optimum dar und erfreuen sich deshalb auf dem Markt wachsender Beliebtheit.

Jede gesteuerte Phase für sich wird bei einem elektronischen Schaltgerät durch mindestens ein Bauelement, in der Regel einen Leistungshalbleiter geschaltet. Derartige Bauelemente erzeugen eine oft nennenswerte Verlustwärme, welche über einen Kühlkörper abgeführt werden muss. In vielen Anwendungen ist es außerdem sinnvoll bzw. bekannt, das Bauelement bzw. den Leistungshalbleiter in dessen dauerhaft durchgeschaltetem EIN-Zustand durch ein mechanisches Schaltglied zu überbrücken und somit den Stromfluss über das mechanische Schaltglied und nicht mehr über den Leistungshalbleiter zu führen. Durch eine derartige sogenannte Bypassschaltung gelingt es, die Verlustwärme eines Leistungshalbleiters im dauerhaft eingeschalteten Zustand drastisch zu reduzieren. In derartigen Schaltgeräten ergibt sich somit für jede elektrische Phase eine Paarung bestehend aus dem Halbleiterschaltelement und einem mechanischen Schaltelement.

Da Schaltgeräte in der Regel für hohe Leistungen, d.h. hohe Spannungen und Ströme konzipiert sind, müssen die einzelnen Phasen elektrisch gegeneinander isoliert angeordnet werden. Hierbei sind geometrische Abstände einzuhalten, welche von der Höhe der von den Phasen geführten Spannungen abhängig sind. Je höher die Spannung, desto größer muss der entsprechende Abstand sein. Für elektronische Schaltgeräte kleinerer Leistung, d.h. z.B. unterhalb 22kW, werden die jeweils einer Phase zugeordneten Leistungs- bzw. Steuerstromkreise auf einer oder auf mehreren Leiterplatten angeordnet. Ziel hierbei ist es stets, die Leiterplattenfläche optimal auszunutzen, jedoch dabei die oben genannten Sicherheitsabstände einzuhalten. Durch die zusätzliche Anforderung, die Halbleiterschaltelement noch zusätzlich thermisch an einen Kühlkörper anzubinden, entsteht oft für ein Schaltgerät ein hoher Platzbedarf bezüglich des Bauraums.

Derzeit ist es bekannt, für ein Schaltgerät einen einzelnen Kühlkörper bereit zu stellen und sämtliche Halbleiterschalter einseitig an den Kühlkörper anzubinden. Auch hierbei müssen die Isolationsabstände nicht nur zwischen den Steuerstromkreisen und den Laststromkreisen, sondern auch zwischen den entsprechenden einzelnen Phasen auf den Leiterplatten berücksichtigt werden, welche die Halbleiterschaltelemente tragen. Derartige Schaltgeräte weisen einen entsprechend hohen Platzbedarf auf.

Es ist außerdem bekannt, jedes Leistungsteil, welches jeweils einer einzigen Phase entspricht, auf einer separaten Leiterplatte anzuordnen, sämtliche mechanischen Überbrückungsschaltglieder auf einer weiteren Leiterplatte anzuordnen und diese vier einzelnen Leiterplatten zusammen mit einer fünften, die Steuerstromkreise enthaltenden Leiterplatte, per Lötung miteinander zu verbinden. Ein derartiger Aufbau ist sehr aufwändig und bedingt zusätzliche Verbindungs- und Isolierteile.

Aufgabe der vorliegenden Erfindung ist es, ein verbessertes Schaltgerät mit zwei gesteuerten Phasen anzugeben.

Die Aufgabe wird gelöst durch ein Schaltgerät mit zwei gesteuerten Phasen, bei dem jede Phase je einer separaten Flachbaugruppe zugeordnet ist. Jede Flachbaugruppe enthält hierbei zumindest ein an einem Kühlkörper zu kühlendes Bauelement. Bei dem Schaltgerät erstreckt sich der Kühlkörper längs in einer Erstreckungsrichtung und besitzt quer zu dieser Erstreckungsrichtung einen T-förmigen Querschnitt. Die Flachbaugruppen sind zu beiden Seiten des Mittelschenkels des Kühlkörpers angeordnet, wobei die zu kühlenden Bauelemente einander zugewandt sind und an je einer Seite des Mittelschenkels anliegen.

Mit anderen Worten zeichnet sich der erfindungsgemäße Aufbau des Schaltgerätes dadurch aus, dass bei dem zweiphasig gesteuerten Schaltgerät diese zwei Phasen auf jeweils eine entsprechende Flachbaugruppe aufgeteilt sind, die sich gegenüberliegen. Zumindest die zu kühlenden Bauelemente sind dabei einander zugewandt, d.h. das Bauelement der einen Flachbaugruppe weist jeweils mit der betreffenden Bestückungsseite zur anderen Flachbaugruppe hin. Die Flachbaugruppen bzw. die zu verschiedenen Phasen gehörenden Bauelemente schließen somit mit anderen Worten den Schenkel des Kühlkörpers zumindest teilweise zwischen sich ein. Jede Flachbaugruppe trägt also jeweils eine einzelne Phase bzw. zumindest den zur entsprechenden Phase gehörenden Laststrompfad.

Das Schaltgerät weist einen platzsparenden und kompakten Aufbau auf. Grund hierfür ist, dass z.B. innerhalb einer einzelnen Flachbaugruppe nur eine einzelne Phase vorhanden ist und somit geometrische Abstände zwischen zwei getrennten Phasen auf einer einzelnen Flachbaugruppe bzw. Platine vermieden sind. Der Aufbau des Schaltgerätes ist klar strukturiert, die Phasen entsprechend getrennt. Durch den übersichtlichen Aufbau ergeben sich eine einfachere Montage und weniger Fehlermöglichkeit.

Der Kühlkörper kann in Erstreckungsrichtung länger als ein einzelnes Bauelement sein und die Bauelement beider Flachbaugruppen in Erstreckungsrichtung überdeckungsfrei bezüglich des Mittelschenkels angeordnet sein. Jedes Bauelement liegt damit - in Erstreckungsrichtung gesehen - nur in einem eigenen Abschnitt des Kühlkörpers an, weshalb der Wärmeeintrag in den Kühlkörper und somit der Wärmeabtransport vom Bauelement auf den gesamten Kühlkörper gleichmäßig verteilt und effizient ist.

Die Kontaktanschlüsse für die Phasen, über welche das Schaltgerät extern verdrahtet wird, können in Erstreckungsrichtung des Kühlkörpers endseitig an den Flachbaugruppen angeordnet sein, Hierdurch können einfach Kontaktanschlüsse verwendet werden, welche direkt in die Flachbaugruppen einbaubar, z.B. einlötbar, sind. Durch einen entsprechend symmetrischen Aufbau sind beispielsweise nur zwei Typen von Anschlussteilen, jeweils für eine der Flachbaugruppen, notwendig. Die Ausführung der Hauptanschlüsse, d.h. der elektrischen Kontaktierung der entsprechenden Anschlüsse der einzelnen Phasen kann also mit wenigen Standardelementen erfolgen.

Insbesondere können die Kontaktanschlüsse für die Phasen bei einer einzelnen Flachbaugruppe jeweils endseitig an beiden Enden in Erstreckungsrichtung des Kühlkörpers angeordnet sein. Das Schaltgerät bzw. die Flachbaugruppe ist dann an beiden Enden längs der Erstreckungsrichtung anschließbar, was zu einer besonders klaren späteren Verdrahtung und auch zu einer einfachen Leitungsführung im Schaltgerät bzw. den Flachbaugruppen führt. Auch hier müssen nur z.B. zwei verschiedene Anschlusselemente für beide Seiten der Flachbaugruppe bevorratet werden.

Das Schaltgerät mit zwei gesteuerten Phasen kann leicht dreiphasig ausgeführt werden, wenn ein zwischen den Flachbaugruppen angeordneter, in Erstreckungsrichtung des Kühlkörpers verlaufender Leiter für eine weitere Phase eingeführt wird.

Da die einzelnen Flachbaugruppen in der Regel eine elektrische Kommunikation untereinander benötigen, kann ein quer zur Erstreckungsrichtung des Kühlkörpers verlaufendes Verbindungsteil zur elektrischen Kontaktierung der Flachbaugruppen vorgesehen sein.

Dies kann ein Steckverbinder sein. Der Steckverbinder weist den Vorteil auf, dass dieser besonders einfach auszuführen ist. Bei der Montage des Schaltgerätes können die Flachbaugruppen jeweils aus seitlicher Richtung auf den Kühlkörper zugeführt werden, um die Bauelemente an diesen anzulegen und hierbei automatisch der Steckverbinder zwischen den beiden Flachbaugruppen zur Verbindung gebracht werden.

Das Verbindungsteil kann auch eine zusätzliche Leiterplatte sein. Diese hat den Vorteil, dass darauf zusätzliche elektrische Bauelemente, z.B. Steuerlogik oder ein Einstellpotentiometer für das Schaltgerät, untergebracht werden können, welche dann z.B. als Schalter o.ä. besonders leicht zugänglich sind.

Die Bauelemente können gegen den Kühlkörper vorgespannt sein. So ist eine besonders gute Wärmeleitfähigkeit zwischen Bauelement und Kühlkörper sicher gestellt. Die Vorspannung kann auf verschiedene Art und Weisen erfolgen, z.B. durch eine das Schaltgerät umfassende Spannklammer. Das gesamte Schaltgerät erhält so mechanische Stabilität.

Zur Vorspannung des Bauelements gegen den Kühlkörper kann auch das Bauelement selbst am Kühlkörper befestigt sein. Da das Bauelement seinerseits in der Regel fest in der Leiterplatte der Flachbaugruppe fixiert ist, z.B. darin massiv eingelötet, erfolgt so außerdem eine automatische Fixierung der Flachbaugruppen am Kühlkörper und damit die mechanische Stabilität des Schaltgerätes. Durch die z.B. beidseitig des Kühlers erfolgende Verschraubung ist das Schaltgerät stabil, so dass die Handhabung in der Montage vereinfacht wird.

Für eine weitere Beschreibung der Erfindung wird auf die Ausführungsbeispiele der Zeichnungen verwiesen. Es zeigen, jeweils in einer stark vereinfachten schematischen Prinzipskizze:
- FIG 1: ein erfindungsgemäßes Schaltgerät in Draufsicht,
- FIG 2: das Schaltgerät aus FIG 1 in Frontansicht,
- FIG 3: eine alternative Ausführungsform des Schaltgerätes mit Verbindungsleiterplatte in einer Darstellung gemäß FIG 2.

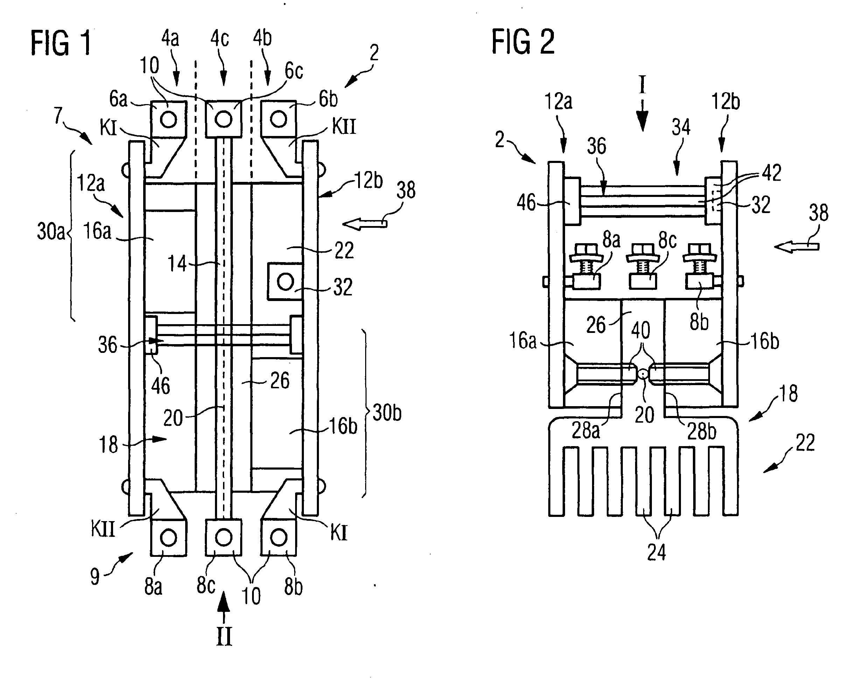

FIG 1 und 2 zeigen in Blickrichtung der Pfeile I, II ein Schaltgerät 2 mit drei Phasen 4a-c, welche jeweils einen Eingang 6a-c und einen Ausgang 8a-c aufweisen und dort über entsprechende Anschlussklemmen 10 an der Seite 7 des Schaltgerätes 2 an eine nicht dargestellte Spannungsversorgung bzw. an der Seite 9 an einen elektrischen Verbraucher anschließbar sind. Die Phasen 4a,b sind geschaltete bzw. gesteuerte Phasen. Die betreffenden Anschlussklemmen 10 führen daher auf jeweils eine Flachbaugruppe 12a,b, welche die am betreffenden Eingang 6a,b eingespeisten Spannungen und Ströme entsprechend beeinflussen, um diese geregelt an den Ausgängen 8a,b zur Verfügung zu stellen. Die Phase 4c ist ungeschaltet, und daher der Eingang 6c mit dem Ausgang 8c über eine durchgehende Leiterbahn 14, im Beispiel ein einfaches Stanzteil, durchverbunden. Aufgrund des symmetrischen Aufbaus der Flachbaugruppen 12a,b sind nur zwei Typen KI und KII von Anschlussklemmen 10 notwendig.

Auf jeder Flachbaugruppe 12a,b ist zur Steuerung der Phasen 4a,b jeweils ein Halbleiter 16a,b in Form eines Leistungshalbleiterschalters angeordnet. Im Betrieb des Schaltgerätes 2 erzeugen die Halbleiter 16a,b eine große Menge Verlustwärme, welche abzuführen ist. Das Schaltgerät 2 enthält daher einen Kühlkörper 18, der eine Erstreckungsrichtung, angedeutet durch die Linie 20, längs des Schaltgerätes 2 aufweist. Im Querschnitt ist der Kühlkörper 18 T-förmig. An seinem Querteil 22 weist der Kühlkörper 18 Kühlrippen 24 auf, vom Querteil 22 weg erstreckt sich der Schenkel 26 des Kühlkörpers.

Die Flachbaugruppen 12a,b sind zueinander parallel angeordnet und schließen den Schenkel 26 zumindest teilweise zwischen sich ein. Zumindest die Halbleiter 16a,b sind so auf den Flachbaugruppen 12a,b bestückt, dass sie sich einander zuwenden. Daher liegt der Halbleiter 16a an der einen Seite 28a und der Halbleiter 16b an der anderen Seite 28b des Schenkels 26 an. In Erstreckungsrichtung 20 des Kühlkörpers 18 dagegen sind die Halbleiter 16a,b überdeckungsfrei angeordnet, nämlich der Halbleiter 16a in einem Längsabschnitt 30a und der Halbleiter 16b in einem Längsabschnitt 30b des Kühlkörpers 18.

Auf der Flachbaugruppe 12b ist außerdem ein Potentiometer 32 angeordnet, welches zur Einstellung nicht näher spezifizierter Parameter des Schaltgerätes 2 dient. Aufgrund der zur Oberseite 34 hin offenen Bauweise des Schaltgerätes 2 ist es von dort aus leicht zugänglich. In FIG 2 ist das Potentiometer 32 gestrichelt dargestellt, da es von einem Verbindungsstecker 36 verdeckt ist, welcher die Flachbaugruppen 12a,b elektrisch, z.B. zum Zwecke deren Kommunikation miteinander, verbindet.

Zur Montage des Schaltgerätes 2 wird zunächst am Kühlkörper 18 die Phase 4c bzw. die entsprechende Leiterbahn 14 in, in den FIG 1.2 nicht dargestellter Weise am Kühlkörper 18 befestigt. Anschließend wird in Richtung des Pfeils 38 die Flachbaugruppe 12b zum Kühlkörper 18 hin bewegt, bis der Halbleiter 16b am Schenkel 26 anliegt. Mit einer in den Halbleiter 16b eingreifenden Schraube 40 wird dieser am Kühlkörper 18 angeschraubt. Da der Halbleiter 16b mittels massiver Kontakte in die Flachbaugruppe 12 eingelötet ist, ist damit die gesamte Flachbaugruppe 12b mechanisch stabil am Kühlkörper 18 befestigt. Der Flachbaugruppe 12b ist ein Steckteil 42 des Verbindungssteckers 36 zugeordnet bzw. an dieser verlötet.

Anschließend wird die Flachbaugruppe 12a in Richtung des Pfeils 44 von der anderen Seite entsprechend an den Kühlkörper 18 angebracht und der Halbleiter 16a mit einer weiteren Schraube 40 befestigt. Hierbei rastet eine an der Flachbaugruppe 12a angebrachte Buchse 46 des Verbindungssteckers 36 in das Steckteil 42 ein, wodurch die elektrische Verbindung der Flachbaugruppen 12a,b hergestellt ist. Durch das Anschrauben mit den Schrauben 40 sind die Halbleiter 16a und b gegen die Seiten 28a,b des Kühlkörpers 18 mechanisch vorgespannt, was eine gute Wärmeleitung sicherstellt.

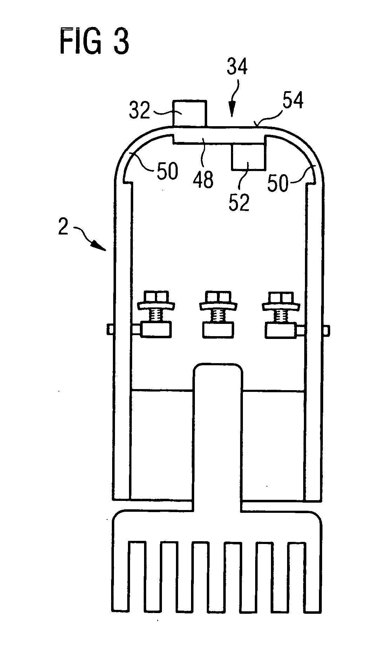

FIG 3 zeigt eine alternative Ausführungsform eines Schaltgerätes 2, bei welcher der Verbindungsstecker 36 durch eine Leiterplatte 48 ersetzt ist, welche über jeweils flexible Anschlussleitungen 50 mit den beiden Flachbaugruppen 12a,b verbunden ist. Da die Leiterplatte 48 zusätzlich Platz zur Positionierung von Bauelementen bietet, ist sowohl das Potentiometer 32 als auch zusätzliche Logikbausteine 52 auf der Leiterplatte 48 angeordnet. Bei gleichem Bauraum wie beim Schaltgerät 2 aus FIG 1,2 ist somit zusätzliche Funktionalität durch die größere zur Verfügung stehende Leiterplattenfläche gegeben. Das Potentiometer 32 ist an der Oberseite 34 des Schaltgerätes 2 noch besser zugänglich als in der Ausführungsform nach FIG 1,2.

Das erfindungsgemäßes Schaltgerät weist - nicht dargestellt - außerdem eine dreiphasige Stromerfassung für eine Überlastrelaisfunktion, einen Thermistorschutz und ein Fehlerausgaberelais auf, ist für Ströme von 38A ausgelegt und besitzt die Abmessungen 45mm x 125mm x 153mm.

## Patentansprüche

1. Drei Phasen-Schaltgerät (2) mit zwei gesteuerten Phasen (4a,b), bei dem jede gesteuerte Phase (4a,b) je einer Flachbaugruppe (12a,b) mit zumindest einem an einem Kühlkörper (18) zu kühlenden Bauelement (16a,b) zugeordnet ist, bei dem der Kühlkörper (18) quer zu seiner Erstreckungsrichtung (20) einen T-förmigen Querschnitt aufweist, und die Flachbaugruppen (12a,b) zu beiden Seiten (28a,b) des Mittelschenkels (26) des Kühlkörpers (18) angeordnet sind, wobei die Bauelemente (16a,b) der beiden Flachbaugruppen (12a,b) einander zugewandt sind und an je einer Seite (28a,b) des Mittelschenkels (26) anliegen.

2. Schaltgerät (2) nach Anspruch 1, bei dem der Kühlkörper (18) in Erstreckungsrichtung (20) länger als das Bauelement (16a,b) ist, und die Bauelemente (16a,b) beider Flachbaugruppen (12a,b) in Erstreckungsrichtung (20) überdeckungsfrei (30a,b) bezüglich des Mittelschenkels (26) angeordnet sind.

3. Schaltgerät (2) nach Anspruch 1 oder 2, mit in Erstreckungsrichtung (20) des Kühlkörpers (18) endseitig (7,9) an den Flachbaugruppen (12a,b) angeordneten Kontaktanschlüssen (10) für die Phasen (4a,b).

4. Schaltgerät (2) nach Anspruch 3, bei dem jede Flachbaugruppe (12a,b) in Erstreckungsrichtung (20) des Kühlkörpers (18) endseitig (7,9) an beiden Enden einen Kontaktanschluss (10) für die Phase (4a,b) aufweist.

5. Schaltgerät 2 nach einem der vorhergehenden Ansprüche, mit einem zwischen den Flachbaugruppen (12a,b) angeordneten, in Erstreckungsrichtung (20) des Kühlkörpers (18) verlaufenden Leiter (14) für eine weitere Phase (4c).

6. Schaltgerät (2) nach einem der vorhergehenden Ansprüche, mit einem quer zur Erstreckungsrichtung (20) des Kühlkörpers (18) verlaufenden Verbindungsteil (36,48) zur elektrischen Kontaktierung der Flachbaugruppen (12a,b).

7. Schaltgerät (2) nach Anspruch 6, bei dem das Verbindungsteil (36,48) ein Steckverbinder ist.

8. Schaltgerät (2) nach Anspruch 6, bei dem das Verbindungsteil (36,38) eine Leiterplatte ist.

9. Schaltgerät (2) nach einem der vorhergehenden Ansprüche, bei dem die Bauelemente (16a,b) gegen den Kühlkörper (18) vorgespannt sind.

10. Schaltgerät (2) nach Anspruch 9, bei dem die Bauelemente (16a,b) am Kühlkörper (18) befestigt sind.

## Claims

1. Three-phase switching device (2) with two controlled phases (4a,b), in which each controlled phase (4a,b) is associated with a respective printed circuit board assembly (12a,b) with at least one component (16a,b) to be cooled on a heat sink (18), in which the heat sink (18) has a T-shaped cross section transversely with respect to its extent direction (20), and the printed circuit board assemblies (12a,b) are arranged on both sides (28a,b) of the center limb (26) of the heat sink (18), with the components (16a,b) of the two printed circuit board assemblies (12a,b) facing one another and resting on in each case one side (28a,b) of the center limb (26).

2. Switching device (2) according to Claim 1, in which the heat sink (18) is longer in the extent direction (20) than the component (16a,b), and the components (16a,b) of the two printed circuit board assemblies (12a,b) are arranged such that they are not coincident (30a,b) with respect to the center limb (26)in the extent direction (20).

3. Switching device (2) according to Claim 1 or 2, with contact connections (10) for the phases (4a,b), which contact connections (10) are arranged at the ends (7, 9) of the printed circuit board assemblies (12a,b) in the extent direction (20) of the heat sink (18).

4. Switching device (2) according to Claim 3, in which each printed circuit board assembly (12a,b) has a contact connection (10) for the phase (4a,b) at both ends, at the ends (7, 9), in the extent direction (20) of the heat sink (18).

5. Switching device (2) according to one of the preceding claims, having a conductor (14) for a further phase (4c), which conductor (14) is arranged between the printed circuit board assemblies (12a,b) and runs in the extent direction (20) of the heat sink (18).

6. Switching device (2) according to one of the preceding claims, with a connection part (36, 48) which runs transversely with respect to the extent direction (20) of the heat sink (18), for making electrical contact with the printed circuit board assemblies (12a,b).

7. Switching device (2) according to Claim 6, in which the connection part (36, 48) is a plug connector.

8. Switching device (2) according to Claim 6, in which the connection part (36, 48) is a printed circuit board.

9. Switching device (2) according to one of the preceding claims, in which the components (16a,b) are prestressed against the heat sink (18).

10. Switching device (2) according to Claim 9, in which the components (16a,b) are attached to the heat sink (18).

## Revendications

1. Commutateur ( 2 ) ayant deux phases ( 4a, b ) commandées, dans lequel à chaque phase ( 4a, b ) est associé respectivement un module ( 12a, b ) plat ayant au moins un composant ( 16a, b ) à refroidir sur un dissipateur ( 18 ) de chaleur, dans lequel le dissipateur ( 18 ) de chaleur a une section transversale en forme de T transversalement à la direction ( 20 ) dans lequel il s'étend et les modules ( 12a, b ) plats sont disposés des deux côtés ( 28a, b ) de la branche ( 26 ) médiane du dissipateur ( 18 ) de chaleur, les composants ( 16a, b ) des deux modules ( 12a, b ) plats étant tournés l'un vers l'autre et s'appliquant à respectivement un côté ( 28a, b ) de la branche ( 26 ) médiane.

2. Commutateur ( 2 ) suivant la revendication 1, dans lequel le dissipateur ( 18 ) de chaleur est plus long dans la direction ( 20 ), dans laquelle il s'étend, que le composant ( 16a, b ) et les composants ( 16a, b ) des deux modules ( 12a, b ) plats sont disposés, par rapport à la branche ( 26 ) médiane dans la direction ( 20 ), dans laquelle ils s'étendent, sans ( 30a, b ) recouvrement.

3. Commutateur ( 2 ) suivant la revendication 1 ou 2, ayant des bornes ( 10 ) de contact pour les phases ( 4a, b ), bornes qui sont disposées dans la direction ( 20 ) dans laquelle s'étend le dissipateur ( 18 ) de chaleur, du côté de l'extrémité ( 7, 9 ) sur les modules ( 12a, b ) plats.

4. Commutateur ( 2 ) suivant la revendication 3, dans lequel chaque module ( 12a, b ) plat a, dans la direction ( 20 ) dans laquelle s'étend le dissipateur ( 18 ) de chaleur, du côté ( 7, 9 ) de l'extrémité aux deux extrémités, une borne ( 10 ) de contact pour les phases ( 4a, b ).

5. Commutateur ( 2 ) suivant l'une des revendications précédentes, comprenant un conducteur ( 14 ) pour une autre phase ( 4c ) disposé entre les modules ( 12a, b ) plats et s'étendant dans la direction ( 20 ) dans laquelle s'étend le dissipateur ( 18 ) de chaleur.

6. Commutateur ( 2 ) suivant l'une des revendications précédentes, comprenant une partie ( 36, 48 ) de liaison, qui s'étend transversalement à la direction ( 20 ) dans laquelle s'étend le dissipateur ( 18 ) de chaleur, et qui est destinée à la mise en contact électrique des modules ( 12a, b ) plats.

7. Commutateur ( 2 ) suivant la revendication 6, dans lequel la partie ( 36, 48 ) de liaison est un connecteur à fiche.

8. Commutateur ( 2 ) suivant la revendication 6, dans lequel la partie ( 36, 48 ) de liaison est une plaquette à circuit imprimé.

9. Commutateur ( 2 ) suivant l'une des revendications précédentes, dans lequel les composants ( 16a, b ) sont précontraints contre le dissipateur ( 18 ) de chaleur.

10. Commutateur ( 2 ) suivant la revendication 9, dans lequel les éléments ( 16a, b ) sont fixés au dissipateur ( 18 ) de chaleur.
